# EUROPEAN PATENT APPLICATION

(11) **EP 4 835 177 A1**
(43) Date of publication of application: **04.11.2026**
(21) Application number: 24909930.0
(22) Date of filing: 30.08.2024
(51) Int. Cl.: C30B 29/22, C30B 29/66, C30B 7/14, H01M 4/525, H01M 4/505

(54) **METAL OXIDE PRECURSOR, AND PREPARATION METHOD THEREFOR AND USE THEREOF**

(30) Priority: 29.12.2023 CN 202311867450
(71) Applicant: HUAYOU NEW ENERGY TECHNOLOGY (QUZHOU) CO., LTD., Quzhou, Zhejiang 324000 (CN); ZHEJIANG HUAYOU COBALT CO., LTD., Jiaxing, Zhejiang 314000 (CN)
(72) Inventor: XU, Wei, Quzhou, Zhejiang 324000 (CN); GUO, Xing, Quzhou, Zhejiang 324000 (CN); ZHAO, Haiying, Quzhou, Zhejiang 324000 (CN); HUANG, Zhenhua, Quzhou, Zhejiang 324000 (CN)
(74) Representative: MERH-IP Matias Erny Reichl Hoffmann Patentanwälte PartG mbB
(86) International application number: PCT/CN2024/115784
(87) International publication number: WO 2025/138981

(57) **Abstract**

A metal oxide precursor, a preparation method therefor, and use thereof are disclosed. The metal oxide precursor is a single-crystal structure, with a crystal being in an incompletely developed octahedral-like structure. Taking a fully developed regular octahedral structure, which is simulated based on the incompletely developed octahedral-like structure, as a reference, a crystal development degree θ of the octahedral-like structure is 33% to 95%, θ=L₁/L₂, in which, L₁ is an edge length of any crystal development edge in the octahedral-like structure, and L₂ is an edge length of a crystal edge when a corresponding crystal development edge is simulated to be fully developed. The metal oxide precursor of the present application has an octahedral-like structure, which can improve the structural stability and energy density when used to prepare the cathode material, so that the battery has excellent cycle stability.

## Description

The present application claims the priority of the Chinese patent application with application number 202311867450.6 and titled "Metal oxide precursor, preparation method therefor, and use thereof" filed with the Chinese Patent Office on December 29, 2023, and all the contents thereof are incorporated by reference into the present application.

### TECHNICAL FIELD

The present application relates to the field of battery technology, and in particular to a metal oxide precursor, a preparation method therefor, and use thereof.

### BACKGROUND

The statements here only provide background information related to the present application and do not necessarily constitute prior art. The precursor synthesized by the coprecipitation method is usually a polycrystalline structure. Since there are multiple grains and grain boundaries in the polycrystalline structure, the grains are not only arranged loosely, but also have more grain boundaries and defects. On the one hand, the cathode material after sintering has a low degree of crystallinity and uneven grain size, which is easy to be crushed during the compaction process. In addition, the cations are easy to destroy the structure of the cathode material during the insertion and removal process, resulting in poor structural stability of the cathode material, thereby affecting the cycle life and stability of the battery; on the other hand, the diffusion path of the cations in the lattice is long, which will affect the migration rate of the cations and the discharge rate of the battery.

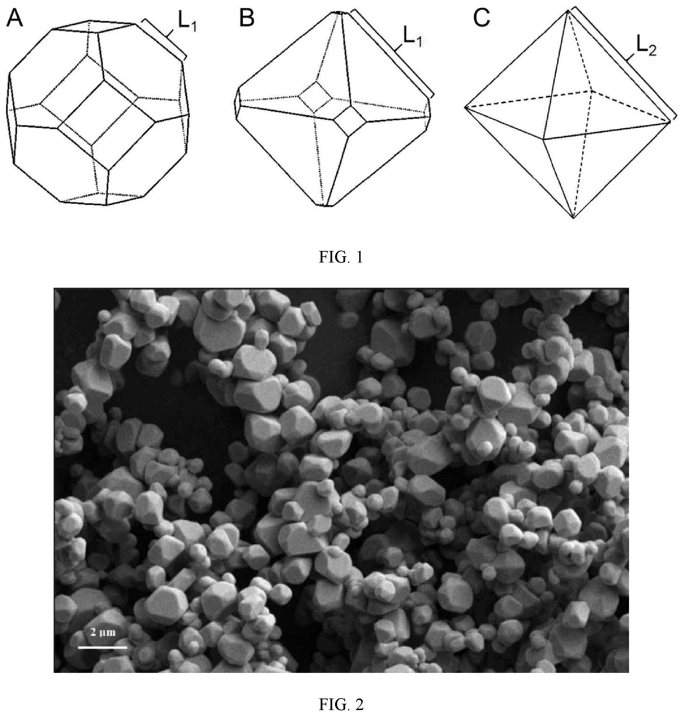

The precursor prepared by the traditional spray pyrolysis process is usually a regular octahedral structure (as shown in C in FIG. 1, the crystal structure is fully developed). Although this structure has high stability, it has low activity and requires higher energy when sintering to form the cathode, which puts higher requirements and challenges on the production process and energy consumption.

### SUMMARY

It is one of objectives of embodiments of the present application to provide a metal oxide precursor, a preparation method thereof, and an application thereof, aiming to solve the problem that the precursor prepared by the traditional spray pyrolysis process is usually a regular octahedral structure, which has low activity and requires higher energy when sintering to form the cathode, which puts higher requirements and challenges on the production process and energy consumption.

Technical solutions adopted by the embodiments of the present application are as follows:
In the first aspect, a metal oxide precursor is provided. The metal oxide precursor is a single-crystal structure, with a crystal being in an incompletely developed octahedral-like structure. Taking a fully developed regular octahedral structure, which is simulated based on the incompletely developed octahedral-like structure, as a reference, a crystal development degree θ of the octahedral-like structure is 33% to 95%, θ=L₁/L₂, in which, L₁ is an edge length of any crystal development edge in the octahedral-like structure, and L₂ is an edge length of a crystal edge when a corresponding crystal development edge is simulated to be fully developed, that is, L₂ is the edge length of the crystal edge in the regular octahedral structure corresponding to the L₁ crystal development edge.

In one embodiment, L₁ is 0.1 µm to 4.3 µm.

In one embodiment, a single-crystal particle growth rate of the metal oxide precursor is η=L₁/H₁, wherein L₁ is an edge length of any crystal development edge in the octahedral-like structure, and H₁ is a single-crystal particle size of the octahedral-like structure.

In one embodiment, the single-crystal particle growth rate of the metal oxide precursor is 23% to 67%.

In one embodiment, the single-crystal particle growth rate of the metal oxide precursor is 38% to 58%.

In one embodiment, the single-crystal particle growth rate of the metal oxide precursor is 35% to 63%.

In one embodiment, a single-crystal particle size of the metal oxide precursor is 0.43 µm to 6.43 µm.

In one embodiment, a crystal surface area of the metal oxide precursor accounts for 88.72% to 99.99% of a crystal surface area of a metal oxide precursor having a crystal development degree of 100%

In one embodiment, a crystal volume of the metal oxide precursor accounts for 95.23% to 99.99% of a crystal volume of a metal oxide precursor having a crystal development degree of 100%

In one embodiment, a ratio of a crystal surface area to a crystal volume of the metal oxide precursor is 1.62 µm⁻¹ to 26.03 µm⁻¹.

In one embodiment, the metal oxide precursor comprises a first crystal and/or a second crystal, a crystal development degree of the first crystal is 33% ≤ θ₁ ≤ 65%, and a crystal development degree of the second crystal is 65% < θ₂ ≤ 95%.

In one embodiment, the metal oxide precursor comprises a first crystal and/or a second crystal, an edge length of a development edge in the first crystal is 0.1 µm to 2.95 µm, and an edge length of a development edge in the second crystal is 0.2 µm to 4.3 µm.

In one embodiment, the metal oxide precursor comprises a first crystal and/or a second crystal, a ratio of a crystal surface area to a crystal volume in the first crystal is 1.63 µm⁻¹ to 26.03 µm⁻¹, and a ratio of a crystal surface area to a crystal volume in the second crystal is 1.62 µm⁻¹ to 24.48 µm⁻¹.

In one embodiment, a general chemical formula of the metal oxide precursor is AₓM_{y}O₂, in which, 0.9 ≤ x ≤ 1, 0 ≤ y ≤ 0.1, A is at least one selected from Ni, Fe, Cu, Mn, and Co, and M is at least one selected from Mg, Al, Sn, Ca, W, Ti, Zn, Li, Na, Mo, La, and Zr.

In a second aspect, a preparation method for the metal oxide precursor as described in the above is provided. The preparation method is selected from spray pyrolysis.

In one embodiment, a pyrolysis temperature of the spray pyrolysis is 460°C to 1110°C.

In one embodiment, a pyrolysis time of the spray pyrolysis is 1 min to 30 min.

In a third aspect, a cathode material prepared from the metal oxide precursor described above or the metal oxide precursor prepared by the method described above is provided.

In a fourth aspect, a cathode plate is provided, comprising: a cathode current collector, and a cathode material layer disposed on a surface of the cathode current collector, in which, the cathode material layer comprises the cathode material as described in the above.

In a fifth aspect, a secondary battery is provided, comprising a cathode plate as described in the above.

Advantages of the metal oxide precursor provided in the embodiments of the present application are summarized as follows: the ratio of the edge length of the crystal development edge in the octahedron-like structure to the edge length of the crystal edge in the theoretically fully developed regular octahedron structure is adopted to evaluate the crystal development degree of the metal oxide precursor. When the crystal development degree of the metal oxide precursor is 33% to 95%, the octahedron-like structure of the metal oxide precursor has an overall structure that is highly inclined to a regular octahedron, in addition, the six edges and corners in the octahedron-like structure are incompletely developed, forming six unsaturated development facets, so that the metal oxide precursor has an octahedron-like structure with fourteen faces. On the one hand, the metal oxide precursor has high symmetry, orderly lattice, good structural stability, and can maintain good crystallinity during the preparation of the cathode material, which is beneficial to improve the structural stability of the cathode material and the cycle stability of the battery; on the other hand, the diffusion path of cations in the octahedral-like structure of the metal oxide precursor is short, which is beneficial to improve the migration rate of cations, thereby increasing the reserve and providing a higher energy density for the cathode material. In addition, the metal oxide precursor of the embodiments of the present application not only improves the structural stability, but also overcomes the defects of the traditional octahedral structure precursor such as low activity, high difficulty in preparing the cathode, and high cost, and has a high market application potential.

Advantages of the preparation method for the metal oxide precursor provided in the embodiments of the present application are summarized as follows: a metal oxide precursor in single-crystal particle with an incompletely developed octahedral-like structure can be prepared by the spray pyrolysis, and taking a fully developed regular octahedral structure, which is simulated based on the incompletely developed octahedral-like structure, as a reference, the crystal development degree θ of the octahedral-like structure is 33% to 95%. Its structural characteristics make the prepared metal oxide precursor have high symmetry, lattice order, structural stability, and other characteristics, improve the structural stability of the cathode material and the cycle stability of the battery; it is also beneficial to increase the reactive specific surface area of the metal oxide precursor, and shorten the ion diffusion path, thereby improving the electrochemical properties such as ion the migration efficiency and the energy storage performance of the cathode material.

Advantages of the cathode material provided in the embodiments of the present application are summarized as follows: the use of the above-mentioned metal oxide precursor in the preparation of the cathode material can not only improve the crystallinity of the cathode material, but also make the cathode material have a higher energy density, which is beneficial to improve the cycle performance of the battery.

Advantages of the cathode plate provided in the embodiments of the present application are summarized as follows: the cathode material with higher energy density, cycle stability, and other characteristics, when applied to the cathode plate, can improve the electrochemical properties of the cathode plate such as energy density and cycle stability.

Advantages of the secondary battery provided in the embodiments of the present application are summarized as follows: the cathode plate having high energy density, cycle stability, and other characteristics, when applied to the secondary battery, can improve the electrochemical properties of the secondary battery such as cycle stability and cycle life.

### BRIEF DESCRIPTION OF THE DRAWINGS

In order to more clearly illustrate the technical solutions in the embodiments of the present application, the drawings required for use in the embodiments or exemplary technical descriptions will be briefly introduced below. Obviously, the drawings described below are only some embodiments of the present application. For ordinary technicians in this field, other drawings can be obtained based on these drawings without paying creative work.
FIG. 1 is a schematic diagram of the crystal structure of a metal oxide precursor, in which, part A is a schematic diagram of the octahedral-like structure of the first crystal, part B is a schematic diagram of the octahedral-like structure of the second crystal, and part C is a schematic diagram of a simulated fully developed regular octahedral structure; L₁ is an edge length of any crystal development edge in the octahedral-like structure of the first crystal or the second crystal, and L₂ is an edge length of a crystal edge when the corresponding crystal development edge is simulated to be fully developed; that is, L₂ is the edge length of the crystal edge in the regular octahedral structure corresponding to the L₁ crystal development edge;
FIG. 2 is a scanning electron microscope image of a metal oxide precursor obtained in Example 1 of the present application;
FIG. 3 is a scanning electron microscope image of a metal oxide precursor obtained in Example 3 of the present application;
FIG. 4 is a scanning electron microscope image of a metal oxide precursor obtained in Example 6 of the present application; and
FIG. 5 is a scanning electron microscope image of a metal oxide precursor obtained in Comparative Example 3 of the present application.

### DETAILED DESCRIPTION OF THE EMBODIMENTS

In order to make the purpose, technical solution and advantages of the present application clearer, the present application is further described in detail in conjunction with the accompanying drawings and embodiments. It should be understood that the specific embodiments described herein are only used to explain the present invention and are not used to limit the present application.

It should be noted that when a component is referred to as being "fixed to" or "arranged on" another component, it can be directly on the other component or indirectly on the other component. When a component is referred to as being "connected to" another component, it can be directly or indirectly connected to the other component. The orientation or position relationship indicated by the terms "upper", "lower", "left", "right", etc. is based on the orientation or position relationship shown in the drawings, and is only for the convenience of description, and does not indicate or imply that the device or element referred to must have a specific orientation, be constructed and operated in a specific orientation. Therefore, it cannot be understood as a limitation of the present application. For ordinary technicians in this field, the specific meanings of the above terms can be understood according to specific circumstances. The terms "first" and "second" are only used for the purpose of convenience of description, and cannot be understood as indicating or implying relative importance or implicitly indicating the number of technical features. "Multiple" means two or more, unless otherwise clearly and specifically defined.

In order to illustrate the technical solution described in the present application, the following is a detailed description in combination with specific drawings and embodiments.

Some embodiments of the present application provide a metal oxide precursor. The metal oxide precursor is a single-crystal structure, with a crystal being in an incompletely developed octahedral-like structure. In combination with FIG. 1, taking a fully developed regular octahedral structure (as shown in part C in FIG. 1), which is simulated based on the incompletely developed octahedral-like structure (as shown in part A and part B in FIG. 1), as a reference, a crystal development degree θ of the octahedral-like structure is 33% to 95%, θ=L₁/L₂, in which, L₁ is an edge length of any crystal development edge in the octahedral-like structure, and L₂ is an edge length of a crystal edge when a corresponding crystal development edge is simulated to be fully developed, that is, L₂ is the edge length of the crystal edge in the regular octahedral structure corresponding to the L₁ crystal development edge.

It should be noted that the edge length of the fully developed crystal edge is equivalent to the crystal edge length of the metal oxide precursor when the crystal development degree is 100% (i.e., developed to a regular octahedral structure), which is the theoretical edge length. The metal oxide precursor crystal of the embodiment of the present application has an incompletely developed octahedral-like structure that is easily inherited by the cathode material.

In the embodiment of the present application, the ratio of the edge length of the crystal development edge in the octahedron-like structure to the edge length of the crystal edge in the theoretically fully developed regular octahedron structure is adopted to evaluate the crystal development degree of the metal oxide precursor. When the crystal development degree of the metal oxide precursor is 33% to 95%, the octahedron-like structure of the metal oxide precursor has an overall structure that is highly inclined to a regular octahedron, in addition, the six edges and corners in the octahedron-like structure are incompletely developed, forming six unsaturated development facets, so that the metal oxide precursor has an octahedron-like structure with fourteen faces. In this case, the metal oxide precursor of the embodiment of the present application has at least the following performance advantages:
On the one hand, the octahedral-like structure of the metal oxide precursor has the characteristic of being highly inclined to the regular octahedral structure, so that its crystal structure still has high symmetry, and the lattice is ordered, the structure is stable, and it can maintain good crystallinity during the preparation of the cathode material, which is beneficial to improve the structural stability of the cathode material and the cycle stability of the battery; on the other hand, the octahedral-like structure of the metal oxide precursor has fourteen faces, which increases its active specific surface area, and the diffusion path of cations in the octahedral-like structure of the metal oxide precursor is short, which is beneficial to improve the migration rate of cations, thereby increasing the reserve and providing a higher energy density for the cathode material. If the crystal development degree θ of the octahedral-like structure is lower than 33%, the structural stability, symmetry, lattice order, and other characteristics of the octahedral-like structure will be destroyed, which is not conducive to improving the electrochemical properties such as the structural stability and cycle stability of the cathode material. If the crystal development degree θ of the octahedral-like structure is higher than 95%, the effect of improving the reactive specific surface area of the metal oxide precursor is poor, which is not conducive to shortening the ion diffusion path, and thus being not conducive to improving the electrochemical properties of the cathode material, such as the ion migration efficiency and energy storage performance.

Exemplarily, the crystal development degree θ of the octahedral-like structure may be 33%, 35%, 40%, 50%, 60%, 70%, 80%, 90%, 95%, or any other typical but non-limiting arbitrary point values or interval values between any two point values.

Since the incompletely developed octahedral-like structure in the metal oxide precursor of the embodiment of the present application is simulated as a fully developed regular octahedral structure as a reference, the edge length L₁ of any crystal development edge in the octahedral-like structure will be lower than the edge length L₂ of the crystal edge corresponding to the L₁ crystal development edge in the regular octahedral structure.

In some embodiments, the edge length L₂ of the crystal edge in the fully developed regular octahedral structure is 0.105 µm to 13.03 µm.

In some embodiments, the edge length L₁ of any crystal development edge in the octahedral-like structure is 0.1 µm to 4.3 µm. In such condition, the crystal development degree of the octahedral-like structure is calculated according to the formula θ=L₁/L₂, and the crystal development degree of the octahedral-like structure in the metal oxide precursor is calculated to be 33% to 95%, which is beneficial to maintain the symmetry, lattice order, and structural stability of the octahedral-like structure, improve the structural stability of the cathode material, and the cycle stability of the battery, and make the octahedral-like structure have fourteen faces, increase its active specific surface area, and make the migration rate of cations higher.

Exemplarily, the edge length L₁ of any crystal development edge in the octahedral-like structure may be 0.1 µm, 0.5 µm, 1 µm, 1.5 µm, 2 µm, 2.5 µm, 3 µm, 4 µm, 4.3 µm, or any other typical but non-limiting arbitrary point values or interval values between any two point values.

Since the crystal development degree of the metal oxide precursor in the embodiment of the present application is 33% to 95%, the single-crystal particle size of the metal oxide precursor is also lower than the single-crystal particle size of the metal oxide precursor when the crystal development degree is 100% (i.e., regular octahedral structure).

In some embodiments, a single-crystal particle size of the regular octahedral structure is 0.148 µm to 18.43 µm.

In some embodiments, the single-crystal particle size of the metal oxide precursor (i.e., the single-crystal particle size of the octahedral-like structure) is 0.43 µm-6.43 µm. Under the single-crystal particle size condition, within this range, the single-crystal particle size belongs to a medium particle size, which can strike a balance between the electrochemical performance and the mechanical stability, and provide good comprehensive performance. If the particle size is too large: the ion transmission path is long, which reduces the charge and discharge rate; the specific surface area is low, which reduces the electrochemical reaction rate and affects the capacity and power density of the battery; too large a size can also easily make the electrode structure uneven. If the particle size is too small: it is easy to cause particle agglomeration and rupture during the charge and discharge process, affecting the cycle performance; although the small size increases the reaction sites, it also increases the side reactions, which will also affect the stability and life of the battery; too small particles will also reduce conductivity.

Exemplarily, the single-crystal particle size of the metal oxide precursor (i.e., the single-crystal particle size of the octahedral-like structure) may be 0.43 µm, 0.5 µm, 1 µm, 2 µm, 3 µm, 4 µm, 5 µm, 6 µm, 6.43 µm, or any other typical but non-limiting arbitrary point values or interval values between any two point values.

In some embodiments, in the metal oxide precursor of the embodiment of the present application, the single-crystal particle growth rate of the octahedral-like structure can be calculated by measuring the edge length of the crystal development edge and the single-crystal particle size. The ratio of the edge length L₁ of any crystal development edge in the octahedral-like structure to the single-crystal particle size H₁ can be used to represent the single-crystal particle growth rate of the metal oxide precursor, and the single-crystal particle growth rate is calculated as η, η=L₁/H₁. For example: when the edge length L₁ of the crystal development edge in the metal oxide precursor is 0.1 µm to 4.3 µm and the single-crystal particle size H₁ is 0.43 µm to 6.43 µm, the single-crystal particle growth rate η is calculated to be 23% to 67%.

In other embodiments, in the metal oxide precursor of the embodiment of the present application, the single-crystal particle growth rate of the octahedral-like structure can also be calculated by the relationship between the single-crystal particle size of the metal oxide precursor when the crystal development degree is 100% under ideal conditions and the single-crystal particle size of the incompletely developed metal oxide precursor. For example, under ideal conditions, when the crystal development degree is 100%, the metal oxide precursor is a regular octahedral structure composed of 8 equilateral triangles, and its single-crystal particle size is counted as H₂, ${H}_{2} = \sqrt{2} \times {L}_{2}$, then the single-crystal particle size of the incompletely developed metal oxide precursor is H₁=H₂×(1+θ)/2, therefore, $η = {L}_{1} / {H}_{1} = \frac{\sqrt{2} \times θ}{1 + θ}$, the single-crystal particle growth rate is calculated to be 35% to 63%.

Exemplarily, the single-crystal particle growth rate of octahedral-like structure in the metal oxide precursor may be 23%, 30%, 35%, 38%, 40%, 45%, 50%, 55%, 58%, 60%, 63%, 67%, or any other typical but non-limiting arbitrary point values or interval values between any two point values.

In some embodiments, the single-crystal particle growth rate of the metal oxide precursor is 38% to 58%. In this case, the single-crystal particle growth rate is higher, the crystal development degree is higher, the structure is very stable, and the difficulty and energy consumption of sintering process to prepare the cathode are higher. If the growth rate is too low, it means that it has not been fully developed, which will lead to poor crystallinity and increased crystal defects, then reduce the electrochemical activity of the material and lead to a decrease in battery capacity.

Considering that the crystal development degree of the metal oxide precursor of the embodiment of the present application is 33% to 95%, compared with the metal oxide precursor having a crystal development degree of 100%, the metal oxide precursor of the embodiment of the present application also has certain differences in crystal surface area and crystal volume.

In some embodiments, a crystal surface area of the metal oxide precursor accounts for 88.72% to 99.99% of a crystal surface area of the metal oxide precursor when the crystal development degree is 100%. That is, taking the crystal surface area of the regular octahedral structure as 100%, in the metal oxide precursor, the crystal surface area of the octahedral-like structure account for 88.72% to 99.99% of the crystal surface area of the regular octahedral structure. In this case, it is beneficial to maintain the structural stability, symmetry, lattice order, and other characteristics of the octahedral-like structure, and it is also beneficial to increase the reactive specific surface area of the metal oxide precursor, and shorten the ion diffusion path, thereby improving the electrochemical properties such as ion the migration efficiency and the energy storage performance of the cathode material.

Exemplarily, when the crystal surface area of the metal oxide precursor accounts for 100% of the crystal development degree, the crystal surface area of the metal oxide precursor may be 88.72%, 90%, 91%, 92%, 93%, 94%, 95%, 96%, 97%, 98%, 99%, 99.99%, or any other typical but non-limiting point value or an interval value between any two point values.

In some embodiments, a crystal volume of the metal oxide precursor accounts for 95.23% to 99.99% of a crystal volume of the metal oxide precursor when the crystal development degree is 100%. That is, taking the crystal volume of the regular octahedral structure as 100%, the crystal volume of the octahedral-like structure in the metal oxide precursor accounts for 95.23% to 99.99% of the crystal volume of the regular octahedral structure. In this case, it is beneficial to maintain the structural stability, symmetry, lattice order, and other characteristics of the octahedral-like structure, and it is also beneficial to increase the reactive specific surface area of the metal oxide precursor, and shorten the ion diffusion path, thereby improving the electrochemical properties such as ion the migration efficiency and the energy storage performance of the cathode material.

Exemplarily, the ratio of the crystal volume of the metal oxide precursor to the crystal volume of the metal oxide precursor having a crystal development degree of 100% may be 95.23%, 96%, 97%, 98%, 99%, 99.99%, or any other typical but non-limiting arbitrary point values or interval values between any two point values.

In some embodiments, a ratio of a crystal surface area to a crystal volume of the metal oxide precursor is taken as the relative surface area, and the relative surface area is 1.62 µm⁻¹ to 26.03 µm⁻¹. That is, in the metal oxide precursor, the ratio of the crystal surface area to the crystal volume of the octahedral-like structure is 1.62 µm⁻¹ to 26.03 µm⁻¹. In this case, as the crystal development degree increases, the corresponding crystal surface area and crystal volume also increase, but the ratio therebetween decreases. A smaller ratio means larger particles, a more stable structure, and can also reduce the occurrence of side reactions and extend battery life. Too low a ratio will result in too few active sites, limiting the reaction rate and rate performance of the battery. A larger ratio means more active sites, which is beneficial to improve the electrochemical reaction rate of the electrode material and can shorten the transmission path of ions and electrons inside the material. If the ratio is too high, volume changes may occur more easily during the cycle, resulting in structural instability and increased side reactions. The ratio of crystal surface area to volume must be within the range of 1.62 µm⁻¹ to 26.03 µm⁻¹ to meet the macroscopic geometric characteristics of the octahedral-like structure of the present application, thereby improving the cycle stability while increasing the reaction rate.

Exemplarily, the ratio of the crystal surface area to the crystal volume of the metal oxide precursor is taken as the relative surface area. In this case, the relative surface area may be 1.62 µm⁻¹, 2 µm⁻¹, 5 µm⁻¹, 10 µm⁻¹, 12 µm⁻¹, 15 µm⁻¹, 18 µm⁻¹, 20 µm⁻¹, 22 µm⁻¹, 24 µm⁻¹, 26 µm⁻¹, 26.03 µm⁻¹, or any other typical but non-limiting arbitrary point values or interval values between any two point values.

The metal oxide precursor of the embodiment of the present application has a specific relative surface area while satisfying the crystal development degree of 33% to 95%, and also has a specific crystal surface area ratio and a specific crystal volume ratio with the metal oxide precursor having a crystal development degree of 100%. By limiting the structure of the metal oxide precursor of the embodiment of the present application, it is beneficial to improve the structural stability of the cathode material and the cycle stability of the battery, thereby improving the electrical performance.

It should be noted that the crystal surface area of the metal oxide precursor having the crystal development degree of 100% is the theoretical crystal surface area; and the crystal volume of the metal oxide precursor having the crystal development degree of 100% is the theoretical crystal volume.

In some embodiments, in conjunction with FIG. 1, the metal oxide precursor includes a first crystal and/or a second crystal, and the first crystal and the second crystal have different crystal development degrees. As shown in part A of FIG. 1, the lower the crystal development degree, the larger and more obvious the six unsaturated development sections are; as shown in part B of FIG. 1, the higher the crystal development degree, the smaller the six unsaturated development sections are, and they tend to form corners.

In some embodiments, the metal oxide precursor includes a first crystal and/or a second crystal, the crystal development degree of the first crystal is 33% ≤ θ₁ ≤ 65%, and the crystal development degree of the second crystal is 65% < θ₂ ≤ 95%. In this case, if the crystallinity is too high: the sintering activity of the precursor is reduced, the sintering is more difficult, the sintering temperature required is higher, there will be risks of grain growth and agglomeration, and the electrochemical performance will be affected. If the crystallinity is too low: the structure is unstable and it is difficult to sinter into a stable single-crystal cathode structure. The first crystal having a crystal development degree of 33% ≤ θ₁ ≤ 65% has relatively low degree of development, low crystallinity, and high reactivity, helping to form a uniform single-crystal structure during the sintering process. The second crystal having a crystal development degree of 65% < θ₂ ≤ 95% has relatively high degree of development and higher crystallinity, and the structural stability of this material is improved, making the material more stable during the charge and discharge process, reducing capacity attenuation, and extending battery life.

In some embodiments, the metal oxide precursor includes a first crystal and/or a second crystal, an edge length of a development edge in the first crystal is 0.1 µm to 2.95 µm, and an edge length of a development edge in the second crystal is 0.2 µm to 4.3 µm. In this case, the first crystal having an edge length of a development edge of 0.1 µm to 2.95 µm indicates that the crystal development degree is low, the crystal structure is more spherical, and the contact area with the electrolyte is larger, which can improve the rate performance; in addition, the sintering temperature is low, which reduces energy consumption. The second crystal having an edge length of a development edge of 0.2 µm to 4.3 µm indicates that the crystal development degree is within a relatively high range, the crystal structure is more inclined to a regular octahedral structure, has a relatively high degree of crystallinity, which can improve the conductivity of electrons and ions, and have better structural stability during the charge and discharge process.

In some embodiments, the metal oxide precursor includes a first crystal and/or a second crystal, a ratio of a crystal surface area to a crystal volume in the first crystal, that is, the relative surface area of the first crystal is 1.63 µm⁻ to 26.03 µm⁻¹, and a ratio of a crystal surface area to a crystal volume in the second crystal, that is, the relative surface area of the second crystal is 1.62 µm⁻¹ to 24.48 µm⁻¹. In this case, the first crystal having a relative surface area of 1.63 µm⁻¹to 26.03 µm⁻¹ has a low degree of development, ranging from 33% to 65%. The precursor with a low degree of development has a higher relative surface area and more active sites, which helps to improve the initial capacity and charge and discharge rate performance, and the sintering process thereof into the cathode material is easier to control. The second crystal having a relative surface area of 1.62 µm⁻¹ to 24.48 µm⁻¹ has a higher degree of development, ranging from 65% to 95%. The precursor with a high degree of development has a higher degree of crystallinity, which is easy to improve the conductivity and structural stability of the material.

In some specific embodiments, the metal oxide precursor includes the above-mentioned first crystal or second crystal separately. The metal oxide precursor in the embodiment of the present application may be mainly the first crystal or the second crystal.

In other specific embodiments, the metal oxide precursor contains both the first crystal and the second crystal. In this case, by mixing the first crystal and the second crystal of two different development levels, it is easy to improve the conductivity and structural stability of the material; the reaction activity is high, it is easier to sinter to form a uniform single-crystal cathode, the energy consumption is low, and the sintering process is easier to control. In addition, the particle sizes of crystals of different development levels are often different, and the coexistence of large and small particles is conducive to increasing the tap density, thereby increasing the potting volume and reducing the sintering cost.

When the first crystal and the second crystal are mixed and distributed in the metal oxide precursor, the distribution ratio of the first crystal to the second crystal is not limited in the embodiments of the present application. Exemplarily, the ratio of the first crystal to the second crystal may be 30:70, 35:65, 40:60, 45:55, 50:50, 55:45, 60:40, 65:35, 70:30, or any other typical but non-limiting arbitrary point values or interval values between any two point values.

In some embodiments, a general chemical formula of the metal oxide precursor is AₓM_{y}O₂, in which, 0.9 ≤ x ≤ 1, 0 ≤ y ≤ 0.1, x+y=1, A is at least one selected from Ni, Fe, Cu, Mn, and Co, and M is at least one selected from Mg, Al, Sn, Ca, W, Ti, Zn, Li, Na, Mo, La, and Zr. It is understood that the metal oxide precursor in the embodiment of the present application can be a binary metal oxide, a ternary metal oxide, or a quaternary metal oxide, which is not limited in the embodiments of the present application.

Embodiments of the present application provide a preparation method for the above metal oxide precursor, and the preparation method is selected from the spray pyrolysis.

In the preparation method provided by embodiments of the present application, a metal oxide precursor in single-crystal particle with an incompletely developed octahedral-like structure can be prepared by the spray pyrolysis, and taking a fully developed regular octahedral structure, which is simulated based on the incompletely developed octahedral-like structure, as a reference, the crystal development degree θ of the octahedral-like structure is 33% to 95%. Its structural characteristics make the prepared metal oxide precursor have high symmetry, lattice order, structural stability, and other characteristics, improve the structural stability of the cathode material and the cycle stability of the battery; it is also beneficial to increase the reactive specific surface area of the metal oxide precursor, and shorten the ion diffusion path, thereby improving the electrochemical properties such as ion the migration efficiency and the energy storage performance of the cathode material.

It should be noted that the specific operation of the spray pyrolysis can refer to the existing method, and the embodiments of this application will not be repeated.

In some embodiments, the pyrolysis temperature of the spray pyrolysis is 460°C to 1110°C. Under the pyrolysis temperature condition, when the pyrolysis temperature is low, the decomposition and crystallization process is relatively slow, the particle development degree is low, the size is small, the development edge length is shorter, and this type of octahedral-like structure is closer to a spherical shape. As the pyrolysis temperature increases, the decomposition rate accelerates, the particles grow and gradually tend to the optimal thermodynamic equilibrium state, the crystal development degree is high, the development edge length is shorter, and this type of octahedral-like structure is closer to a regular octahedron. Within this pyrolysis temperature range, the crystal development degree is moderate, the conductivity and the structural stability of the material are improved, and it is easier to sinter into a single-crystal cathode material, and the sintering process is easier to control.

It should be noted that the pyrolysis temperature is the working temperature of the pyrolysis device.

In some embodiments, a pyrolysis time of the spray pyrolysis is 1 min to 30 mins. Under this pyrolysis time condition, as the pyrolysis time increases, the pyrolysis is more complete, the crystallinity is higher, and the crystal development degree is higher, that is, the longer the edge length is, the closer the crystal structure is to the regular octahedral structure. Under this pyrolysis time, the precursor has a higher reactivity, the sintering process thereof into the cathode material is easier to control, and the precursor also helps to improve the capacity and the cycle stability.

Exemplarily, the pyrolysis temperature of the spray pyrolysis may be 460°C, 500°C, 600°C, 700°C, 800°C, 900°C, 1000°C, 1100°C, or any other typical but non-limiting arbitrary point values or interval values between any two point values. The pyrolysis time may be 1 min, 5 mins, 10 mins, 15 mins, 20 mins, 25 mins, 30 mins, or any other typical but non-limiting arbitrary point values or interval values between any two point values.

By adjusting the temperature and time of spray pyrolysis, it is beneficial to control the crystal development degree of the metal oxide precursor, so that the metal oxide precursor can inherit the advantages of the octahedral structure while avoiding its complete development, which is beneficial to the formation of an octahedral-like structure with fourteen faces, thereby achieving controllable development of the metal oxide precursor.

Embodiments of the present application further provide a cathode material made from the above metal oxide precursor.

The metal oxide precursor of the embodiments of the present application is used to prepare a cathode material, which can not only improve the crystallinity of the cathode material, but also make the cathode material have a higher energy density, thus being conducive to improving the cycle performance of the battery.

It should be noted that the preparation method of the cathode material refers to the existing method, and embodiments of the present application will not be repeated.

Embodiments of the present application further provide a cathode plate, including a cathode current collector and a cathode material layer arranged on the surface of the cathode current collector, and the cathode material layer includes the above-mentioned cathode material.

In the embodiments of the present application, the cathode material with higher energy density, cycle stability, and other characteristics, when applied to the cathode plate, can improve the electrochemical properties of the cathode plate such as energy density and cycle stability.

Embodiments of the present application further provide a secondary battery, including the above-mentioned cathode plate.

In the embodiments of the present application, the cathode plate having high energy density, cycle stability, and other characteristics, when applied to the secondary battery, can improve the electrochemical properties of the secondary battery such as cycle stability and cycle life.

For example, the secondary battery may be a sodium ion battery.

In some embodiments, the cathode current collector may be a metal foil or a composite current collector, for example, an aluminum foil is used as the metal foil. The composite current collector may be formed by forming a metal material on a polymer material substrate. The metal material includes but is not limited to at least one of aluminum, aluminum alloy, nickel, nickel alloy, titanium, titanium alloy, silver and silver alloy. The polymer material substrate includes but is not limited to at least one of polypropylene (PP), polyethylene terephthalate (PET), polybutylene terephthalate (PBT), polystyrene (PS), and polyethylene (PE).

It can be understood that the cathode material layer also includes a binder and a conductive agent, in which, the binder can be any commercially available binder for cathode plates, including but not limited to at least one of polyvinylidene fluoride (PVDF), polytetrafluoroethylene (PTFE), vinylidene fluoride-tetrafluoroethylene-propylene terpolymer, vinylidene fluoride-fluoropropylene-tetrafluoroethylene terpolymer, tetrafluoroethylene-hexafluoropropylene copolymer and fluorine-containing acrylate resins, or a binder prepared by any known method, which are not limited in the embodiments of the present application. The conductive agent may be any commercially available conductive agent for sodium ion batteries, such as carbon black, graphite, etc.

Hereinafter, the metal oxide precursor, the preparation method therefor, and the use thereof will be described by the following specific examples. However, those skilled in the art will understand that the following examples are only used to illustrate the embodiments of the present application and should not be regarded as limiting the scope of the embodiments of the present application. If the specific conditions are not specified in the embodiments, they are carried out according to conventional conditions or conditions recommended by the manufacturer. If the manufacturer of the reagents or instruments used is not specified, they are all conventional products that can be obtained commercially.

### Example 1

Nickel nitrate, copper nitrate, iron nitrate, and manganese nitrate were dissolved in pure water at a metal atomic molar ratio of 25:5:35:35 to prepare a mixed metal salt solution with a concentration of 200 g/L. The mixed metal salt solution was first atomized under an atomization pressure of 0.4 MPa and an atomization angle of 45°, and then pyrolyzed at 460°C for 5 mins to obtain a metal oxide precursor. The obtained metal oxide precursor product is represented by a simplified formula of NCFM25/5/35/35.

A surface morphology of the metal oxide precursor prepared in this example is shown in FIG. 2. It can be seen that the metal oxide precursor is a single-crystal structure, and its morphology is an octahedral-like structure with six unsaturated development faces, and the area of the unsaturated development facets is large, indicating that the crystal development degree under the spray pyrolysis process is at a low level.

It is found from testing that a single-crystal particle size of the metal oxide precursor is about 0.68 µm, an edge length L₁ of a development edge in the crystal is about 0.48 µm, a theoretical edge length is about 1.33 µm according to the calculation, a crystal development degree θ of the metal oxide precursor is about 36%, and a grain growth rate is about 31.6%. At this crystal development degree, a ratio of a crystal surface area of the metal oxide precursor to a theoretical crystal surface area is about 86.2%, a ratio of a crystal volume of the metal oxide precursor to a theoretical crystal volume is about 90.3%, and a relative surface area of the metal oxide precursor is about 1.87.

### Example 2

Nickel chloride and manganese chloride were dissolved in pure water at a metal atomic molar ratio of 35:65 to prepare a mixed metal salt solution with a concentration of 180 g/L. The mixed metal salt solution was first atomized under an atomization pressure of 0.5 MPa and an atomization angle of 50°, and then pyrolyzed at 800°C for 15 mins to obtain a metal oxide precursor. The obtained metal oxide precursor product is represented by a simplified formula of FM35/65.

It can be seen from the SEM testing that the metal oxide precursor prepared in this example is a single-crystal structure, and its morphology is an octahedral-like structure with six unsaturated development faces, and the area of the unsaturated development facets is smaller than that of Example 1, indicating that the crystal development degree under the spray pyrolysis process is higher than that of Example 1.

It is found from testing that a single-crystal particle size of the metal oxide precursor is about 2.8 µm, an edge length L₁ of a development edge in the crystal is about 1.98 µm, and a theoretical edge length is about 6 µm according to the calculation, a crystal development degree θ of the metal oxide precursor is about 55%, and a grain growth rate is about 38.89%. At this crystal development degree, a ratio of a crystal surface area of the metal oxide precursor to a theoretical crystal surface area is about 91.7%, a ratio of a crystal volume of the metal oxide precursor to a theoretical crystal volume is about 93.83%, and a relative surface area of the metal oxide precursor is about 6.72.

### Example 3

Nickel sulfate and manganese sulfate were dissolved in pure water at a metal atomic molar ratio of 25:75 to prepare a mixed metal salt solution with a concentration of 230 g/L. The mixed metal salt solution was first atomized under an atomization pressure of 0.6 MPa and an atomization angle of 42°, and then pyrolyzed at 1100°C for 25 mins to obtain a metal oxide precursor. The obtained metal oxide precursor product is represented by a simplified formula of NM25/75.

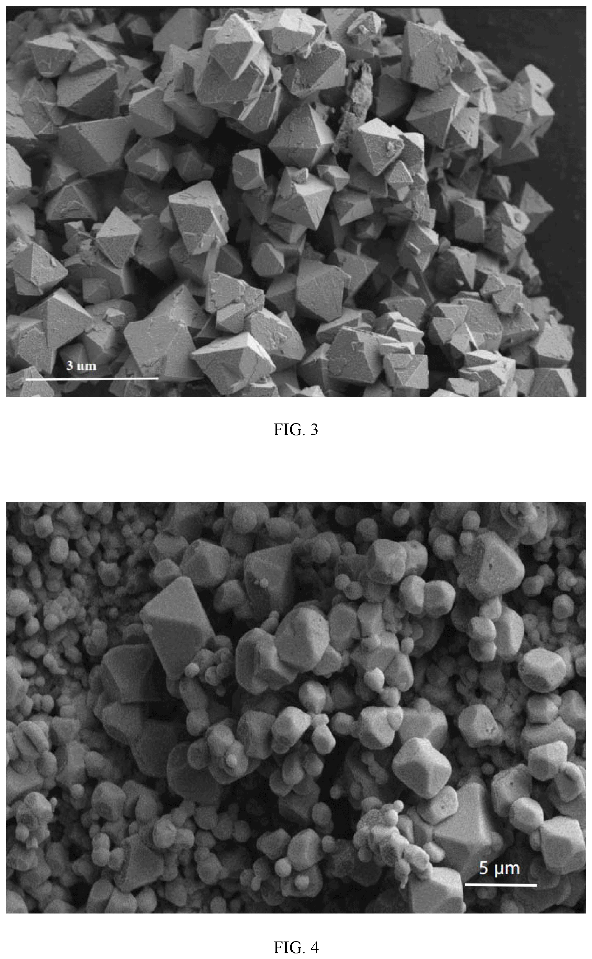

A surface morphology of the metal oxide precursor prepared in this example is shown in FIG. 3. It can be seen that the metal oxide precursor is a single-crystal structure, an area of the unsaturated development section in the structure is small, and its morphology is close to the regular octahedral structure, indicating that the crystal development degree under the spray pyrolysis process is at a high level.

It is found from testing that a single-crystal particle size of the metal oxide precursor is about 5.6 µm, an edge length L₁ of a development edge in the crystal is about 3.96 µm, and a theoretical edge length is about 4.26 µm according to the calculation, a crystal development degree θ of the metal oxide precursor is about 93%, and a grain growth rate is about 65.77%. At this crystal development degree, a ratio of a crystal surface area of the metal oxide precursor to a theoretical crystal surface area is about 97.8%, a ratio of a crystal volume of the metal oxide precursor to a theoretical crystal volume is about 99.3%, and a relative surface area of the metal oxide precursor is about 24.21.

### Example 4

Nickel nitrate, cobalt nitrate, and manganese nitrate were dissolved in pure water at a metal atomic molar ratio of 83:12:5 to prepare a mixed metal salt solution with a concentration of 220 g/L. The mixed metal salt solution was first atomized under an atomization pressure of 0.5 MPa and an atomization angle of 48°, and then pyrolyzed at 500°C for 2 mins to obtain a metal oxide precursor. The obtained metal oxide precursor product is represented by a simplified formula of NCM83/12/5.

It is found from testing that a single-crystal particle size of the metal oxide precursor is about 0.71 µm, an edge length L₁ of a development edge in the crystal is about 0.25 µm, and a theoretical edge length is about 0.76 µm according to the calculation, a crystal development degree θ of the metal oxide precursor is about 33%, and a grain growth rate is about 35.1%. At this crystal development degree, a ratio of a crystal surface area of the metal oxide precursor to a theoretical crystal surface area is about 66.33%, a ratio of a crystal volume of the metal oxide precursor to a theoretical crystal volume is about 88.72%, and a relative surface area of the metal oxide precursor is about 7.25.

### Example 5

Nickel nitrate, cobalt nitrate, and manganese nitrate were dissolved in pure water at a metal atomic molar ratio of 65:15:20 to prepare a mixed metal salt solution with a concentration of 250 g/L. The mixed metal salt solution was first atomized under an atomization pressure of 0.7 MPa and an atomization angle of 55°, and then pyrolyzed at 1100°C for 30 mins to obtain a metal oxide precursor. The obtained metal oxide precursor product is represented by a simplified formula of NCM65/15/20.

It is found from testing that a single-crystal particle size of the metal oxide precursor is about 6.24 µm, an edge length L₁ of the development edge in the crystal is about 4.3 µm, a theoretical edge length is about 4.53 µm according to the calculation, a crystal development degree θ of the metal oxide precursor is about 95%, and a grain growth rate is about 68.9%. At this crystal development degree, a ratio of a crystal surface area of the metal oxide precursor to a theoretical crystal surface area is about 99.81%, a ratio of a crystal volume of the metal oxide precursor to a theoretical crystal volume is about 99.9%, and a relative surface area of the metal oxide precursor is about 1.62.

### Example 6

Nickel acetate, cobalt acetate, and manganese acetate were dissolved in pure water at a metal atomic molar ratio of 60:10:30 to prepare a mixed metal salt solution with a concentration of 210 g/L. The mixed metal salt solution was first atomized under an atomization pressure of 0.6 MPa and an atomization angle of 50°, and then pyrolyzed at 550°C for 5 mins to obtain a first crystal. Under the condition that other conditions remain unchanged, the pyrolysis temperature was changed to 780°C and the pyrolysis time was 18 mins to obtain the second crystal. The first crystal and the second crystal with two different development degrees were mixed at a ratio of 60:40. The obtained metal oxide precursor product is represented by a simplified formula of NCM60/10/30.

A surface morphology of the metal oxide precursor prepared in this example is shown in FIG. 4. It can be seen that a single-crystal structure of the metal oxide precursor contains two octahedral-like structures of different development degrees and particle sizes, in which, a crystal having a larger particle size has a higher crystal development degree, and the crystal having a smaller particle size has a lower crystal development degree.

It is found from testing that a single-crystal particle size of a first crystal in the metal oxide precursor is about 2.48 µm, and an edge length L₁ of a development edge in the crystal is about 1.02 µm, a theoretical edge length is about 2.49 µm according to the calculation, a crystal development degree θ of the metal oxide precursor is about 41%, and a grain growth rate is about 41.1%. At this crystal development degree, a ratio of a crystal surface area of the metal oxide precursor to a theoretical crystal surface area is about 73.89%, a ratio of the crystal volume of the metal oxide precursor to a theoretical crystal volume is about 92.3%, and a relative surface area of the metal oxide precursor is about 2.37.

A single-crystal particle size of a second crystal in the metal oxide precursor is about 5.09 µm, an edge length L₁ of a development edge in the crystal is about 3.39 µm, and a theoretical edge length is about 3.81 µm according to the calculation, a crystal development degree θ of the metal oxide precursor is about 89%, and a grain growth rate is about 66.6%. At this crystal development degree, a ratio of the crystal surface area of the metal oxide precursor to a theoretical crystal surface area is about 99.09%, a ratio of a crystal volume of the metal oxide precursor to a theoretical crystal volume is about 99.95%, and a relative surface area of the metal oxide precursor is about 1.91.

### Comparative Example 1

A difference between Comparative Example 1 and Example 1 is that the pyrolysis temperature was 380°C and the pyrolysis time was 50s.

Because the metal oxide precursor is not completely pyrolyzed under the pyrolysis conditions, the crystal development degree is too low, the single-crystal structure is close to spherical, and basically no prismatic structure appears, and the particle size is very uneven. It is found from testing that the single-crystal particle size of the metal oxide precursor is about 0.38 µm, and the crystal development degree is less than 25%.

### Comparative Example 2

The difference between Comparative Example 2 and Example 2 is that the pyrolysis temperature was 1200°C and the pyrolysis time was 40s.

Because the metal oxide precursor fully reacts under the pyrolysis conditions, the crystal is fully developed, the single-crystal structure presents a basically complete regular octahedral structure, and the particle size is significantly increased. It is found from testing that the single-crystal particle size of the metal oxide precursor is about 9.62 µm, the edge length L₁ of the development edge in the crystal is about 6.8 µm, and the theoretical edge length is about 6.83 µm according to the calculation. The crystal development degree θ of the metal oxide precursor is about 99.5%, and the grain growth rate is about 70.7%. At this crystal development degree, the ratio of the crystal surface area of the metal oxide precursor to the theoretical crystal surface area is about 99.99%, the ratio of the crystal volume of the metal oxide precursor to the theoretical crystal volume is about 99.99%, and the relative surface area of the metal oxide precursor is about 1.08.

### Comparative Example 3

Nickel salt and manganese salt were prepared into a mixed metal salt solution in a metal atomic molar ratio of 25:75 and placed in a reactor. Then, sodium hydroxide solution and ammonia solution were added and nitrogen was introduced. The reaction temperature was controlled at 60°C, the pH value was 10.5, the stirring rate was 500 r/min, and the coprecipitation reaction was carried out for 13 hrs. The metal hydroxide precursor was then obtained by centrifugal washing and drying.

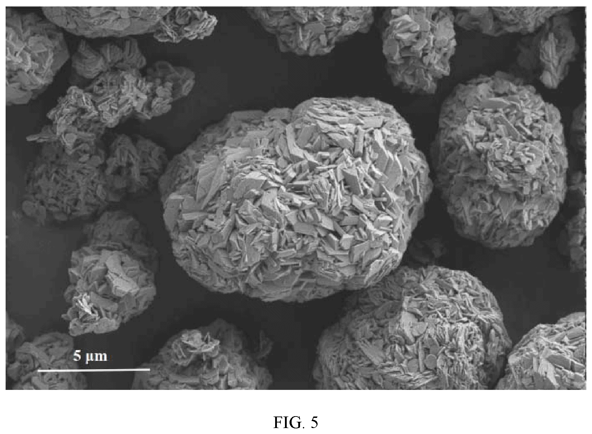

The surface morphology of the metal hydroxide precursor prepared in this comparative example is shown in FIG. 5, which shows that the metal hydroxide precursor is a secondary particle composed of strip-shaped or sheet-shaped primary particles aggregated, presenting a polycrystalline structure, and the particle size is very uneven, distributed between 5 µm and 20 µm.

### Comparative Example 4

The difference between Comparative Example 4 and Example 4 is that the pyrolysis temperature was 430°C and the pyrolysis time was 2 mins.

Because the metal oxide precursor cannot fully react under the pyrolysis conditions, the crystal development degree is too low, the octahedral structure of the single-crystal structure is not very obvious, and it presents a spherical structure, the particle size is extremely small and the agglomeration phenomenon is serious.

The single-crystal particle size of the metal oxide precursor is about 3.18 µm, the edge length L₁ of the development edge in the crystal is about 1.09 µm, and the theoretical edge length is about 3.39 µm according to the calculation, so the crystal development degree θ of the metal oxide precursor is about 32%, and the grain growth rate is about 34.3%. At this crystal development degree, the ratio of the crystal surface area of the metal oxide precursor to the theoretical crystal surface area is about 65.32%, the ratio of the crystal volume of the metal oxide precursor to the theoretical crystal volume is about 88.2%, and the relative surface area of the metal oxide precursor is about 1.61.

### Comparative Example 5

The difference between Comparative Example 5 and Example 5 is that the pyrolysis temperature was 1200°C and the pyrolysis time was 30 mins.

Because the metal oxide precursor fully reacts under the pyrolysis conditions, the crystal is fully developed, the single-crystal structure presents a basically complete regular octahedral structure, and the particle size is significantly increased. It is found from testing that the single-crystal particle size of the metal oxide precursor is about 6.49 µm, the edge length L₁ of the development edge in the crystal is about 4.5 µm, and the theoretical edge length is about 4.69 µm according to the calculation. The crystal development degree θ of the metal oxide precursor is about 96%, and the grain growth rate is about 69.3%. At this crystal development degree, the ratio of the crystal surface area of the metal oxide precursor to the theoretical crystal surface area is about 99.88%, the ratio of the crystal volume of the metal oxide precursor to the theoretical crystal volume is about 99.99%, and the relative surface area of the metal oxide precursor is about 1.57.

### Application Examples

The precursors prepared in Example 1-3 and Comparative Example 1-3 were respectively mixed with sodium carbonate at a molar ratio of 1:1, and then placed in a muffle furnace. In an air atmosphere, the temperature was increased to 900°C at a heating rate of 5°C/min. After constant temperature sintering for 15 hrs, the mixture was naturally cooled, crushed, and sieved to obtain a cathode material.

The precursors prepared in Example 4-6 and Comparative Example 4-5 were respectively mixed with lithium carbonate at a molar ratio of 1:1.05, and then placed in a muffle furnace. In an air atmosphere, the temperature was increased to 950°C at a heating rate of 5°C/min. After constant temperature sintering for 15 hrs, the mixture was naturally cooled, crushed, and sieved to obtain a cathode material.

The cathode materials prepared in Examples 1-3 and Comparative Examples 1-3 were respectively made into sodium ion button batteries, and the discharge specific capacity and the capacity retention rate after 50 cycles were tested under the voltage condition of 2 V to 4.2 V. The cathode materials prepared in Examples 4-6 and Comparative Examples 4-5 were respectively made into lithium ion button batteries, and the discharge specific capacity and the capacity retention rate after 50 cycles were tested under the voltage condition of 2 V to 4.0 V. The test results are shown in Table 1.

**Table 1**

| | Capacity retention rate after 50 cycles (%) | Discharge specific capacity (mAh/g) |
|---|---|---|
| Example 1 | 94.5 | 161 |
| Example 2 | 92.8 | 148 |
| Example 3 | 90.4 | 155 |
| Example 4 | 90.5 | 189.6 |
| Example 5 | 91.1 | 186.0 |
| Example 6 | 93.6 | 190.7 |
| Comparative Example 1 | 74.5 | 131 |
| Comparative Example 2 | 90.2 | 140 |
| Comparative Example 3 | 86.7 | 135 |
| Comparative Example 4 | 77.2 | 171.4 |
| Comparative Example 5 | 85.8 | 154.3 |

According to Table 1, the metal oxide precursors prepared in Examples 1-3 have good cycle stability as cathode materials for sodium ion batteries. The cycle stability of Comparative Examples 1-3 is lower than that of Examples 1-3, especially Comparative Example 3, where the capacity retention rate after 50 cycles is as low as 86.7%, and the cycle stability is poor.

Since the energy density is calculated based on the formula of battery capacity and average voltage: mass energy density (Whkg) = capacity (Ah/kg) × average voltage (V), the cathode specific capacity is proportional to the mass energy density. According to the test results of the discharge specific capacity, the metal oxide precursors prepared in Examples 1-3 and Comparative Examples 1-3 are used to prepare cathode materials for sodium ion batteries, and the cathode materials prepared in Examples 1-3 and Comparative Examples 1-3 are assembled into soft-pack batteries in the same way. Under the same voltage conditions, compared with Comparative Examples 1-3, Example 1-3 has a higher energy density.

The technical features of the above embodiments can be combined arbitrarily. To make the description concise, not all possible combinations of the technical features in the above embodiments are described. However, as long as there is no contradiction in the combination of these technical features, they should be considered to be within the scope of this specification.

The above are only optional embodiments of this application and are not intended to limit this application. For those skilled in the art, this application may have various changes and variations. Any modifications, equivalent substitutions, improvements, etc. made within the spirit and principles of this application should be included in the scope of the claims of this application.

## Claims

1. A metal oxide precursor, **characterized in that**
the metal oxide precursor is a single-crystal structure, with a crystal being in an incompletely developed octahedral-like structure; and
taking a fully developed regular octahedral structure, which is simulated based on the incompletely developed octahedral-like structure, as a reference, a crystal development degree θ of the octahedral-like structure is 33% to 95%, θ=L₁/L₂, in which, L₁ is an edge length of any crystal development edge in the octahedral-like structure, and L₂ is an edge length of a crystal edge when a corresponding crystal development edge is simulated to be fully developed, that is, L₂ is the edge length of the crystal edge in the regular octahedral structure corresponding to the L₁ crystal development edge.

2. The metal oxide precursor according to claim 1, wherein L₁ is 0.1 µm to 4.3 µm.

3. The metal oxide precursor according to claim 1, wherein a single-crystal particle size of the metal oxide precursor is 0.43 µm to 6.43 µm.

4. The metal oxide precursor according to claim 1, wherein a single-crystal particle growth rate of the metal oxide precursor is η=L₁/H₁, wherein L₁ is an edge length of any crystal development edge in the octahedral-like structure, and H₁ is a single-crystal particle size of the octahedral-like structure.

5. The metal oxide precursor according to claim 4, wherein the single-crystal particle growth rate of the metal oxide precursor is 23% to 67%.

6. The metal oxide precursor according to claim 5, wherein the single-crystal particle growth rate of the metal oxide precursor is 35% to 63%.

7. The metal oxide precursor according to claim 6, wherein the single-crystal particle growth rate of the metal oxide precursor is 38% to 58%.

8. The metal oxide precursor according to claim 1, wherein a crystal surface area of the metal oxide precursor accounts for 88.72% to 99.99% of a crystal surface area of a metal oxide precursor having a crystal development degree of 100%.

9. The metal oxide precursor according to claim 1, wherein a crystal volume of the metal oxide precursor accounts for 95.23% to 99.99% of a crystal volume of a metal oxide precursor having a crystal development degree of 100%.

10. The metal oxide precursor according to claim 1, wherein a ratio of a crystal surface area to a crystal volume of the metal oxide precursor is 1.62 µm⁻¹ to 26.03 µm⁻¹.

11. The metal oxide precursor according to any one of claims 1-10, wherein the metal oxide precursor comprises a first crystal and/or a second crystal, a crystal development degree of the first crystal is 33% ≤ θ₁ ≤ 65%, and a crystal development degree of the second crystal is 65% < θ₂ ≤ 95%.

12. The metal oxide precursor according to any one of claims 1-10, wherein the metal oxide precursor comprises a first crystal and/or a second crystal, an edge length of a development edge in the first crystal is 0.1 µm to 2.95 µm, and an edge length of a development edge in the second crystal is 0.2 µm to 4.3 µm.

13. The metal oxide precursor according to any one of claims 1-10, wherein the metal oxide precursor comprises a first crystal and/or a second crystal, a ratio of a crystal surface area to a crystal volume in the first crystal is 1.63 µm⁻¹ to 26.03 µm⁻¹, and a ratio of a crystal surface area to a crystal volume in the second crystal is 1.62 µm⁻¹ to 24.48 µm⁻¹.

14. The metal oxide precursor according to claim 1, wherein a general chemical formula of the metal oxide precursor is AₓM_{y}O₂, in which, 0.9 ≤ x ≤ 1, 0 ≤ y ≤ 0.1, A is at least one selected from Ni, Fe, Cu, Mn, and Co, and M is at least one selected from Mg, Al, Sn, Ca, W, Ti, Zn, Li, Na, Mo, La, and Zr.

15. A preparation method for the metal oxide precursor according to any one of claims 1-14, wherein the preparation method is selected from spray pyrolysis.

16. The preparation method for the metal oxide precursor according to claim 15, wherein a pyrolysis temperature of the spray pyrolysis is 460°C to 1110°C.

17. The preparation method for the metal oxide precursor according to claim 15, wherein a pyrolysis time of the spray pyrolysis is 1 min to 30 mins.

18. A cathode material made from the metal oxide precursor according to any one of claims 1-14 or the metal oxide precursor prepared by the preparation method according to any one of claims 15-17.

19. A cathode plate, **characterized by** comprising: a cathode current collector, and a cathode material layer disposed on a surface of the cathode current collector, wherein the cathode material layer comprises the cathode material according to claim 18.

20. A secondary battery, **characterized by** comprising the cathode plate according to claim 19.
